# EUROPEAN PATENT SPECIFICATION

(11) **EP 0 584 833 B1**
(45) Date of publication and mention of the grant of the patent: **02.01.1997**
(21) Application number: 93113751.7
(22) Date of filing: 27.08.1993
(51) Int. Cl.: C23C 16/26, B21C 3/02

(54) **Diamond wire drawing die and the process for manufacturing the diamond wire drawing die**
Diamant-Drahtziehmatrize und Verfahren zur Herstellung der Diamant-Drahtziehmatrize
Filière en diamant et procédé pour la fabrication de cette filière

(30) Priority: 28.08.1992 JP 230362/92
(43) Date of publication of application: 02.03.1994
(73) Proprietor: SUMITOMO ELECTRIC INDUSTRIES, LIMITED, Osaka 541 (JP)
(72) Inventor: Takahashi, Toshiya, c/o Itami Works, Itami-shi, Hyogo (JP); Ikegaya, Akihiko, c/o Itami Works, Itami-shi, Hyogo (JP); Tanabe, Keiichiro, c/o Itami Works, Itami-shi, Hyogo (JP); Fujimori, Naoji, c/o Itami Works, Itami-shi, Hyogo (JP)
(74) Representative: Füchsle, Klaus, Dipl.-Ing.

(56) References cited:
- EP-A- 0 197 790
- EP-A- 0 339 992
- EP-A- 0 459 425
- EP-A- 0 467 043
- EP-A- 0 494 799
- US-A- 4 016 736

## Description

The present invention relates to a diamond wire drawing die and a diamond plate, especially one made of gaseous phase synthetic diamond.

Diamond has the greatest hardness and highest modulus of elasticity of all known materials. Furthermore, extremely pure diamond has the highest thermal conductivity and the highest transmittance in the infrared spectrum. Thus, diamond is a material for which there are no comparative substitutes.

A method of synthesizing diamond from a gaseous phase is disclosed in U.S. Patent No. 4,767,608 issued August 30, 1988 to Matsumoto, et al. Furthermore, U.S. Patent No. 4,434,188 issued February 28, 1984 to Kamo et al discloses synthesizing diamond from a gaseous phase. Concerning a wire drawing die, a polycrystalline diamond composite is disclosed in U.S. Patent No. 3,831,428 issued August 27, 1974 H. Wentorf. Jr. A composite wire drawing die construction is described in which a centrally-located mass of diamond defines at least the throat of the wire drawing hole, the mass being flanked or girded by at least one mass of metal bonded carbide that is directly bonded thereto. EP-0,391,418-A1 relates to a diamond wire drawing die made of synthesized single crystal diamond provided by the temperature gradient method, and it describes a method of producing wire drawing dies by cleaving diamond.

Since a drawing die is a tool used, for example, for drawing a metal wire, it is required to have properties as follows:
· It must have enough strength to avoid breakage during drawing
· It must have superior wear resistance
· It must be possible to shape it into an appropriate structure and form, and have a final die hole surface which provides the best condition for drawing.

Diamond, which has these properties, is a superior raw material for a wire drawing die.

Before the present invention, a natural single crystal diamond, synthesized single crystal diamond and a poly crystalline diamond composite were used for a central portion of the wire drawing die. But the natural single crystal diamond and the synthesized single crystal diamond are expensive and have faults such as limitation of crystal size and they are easy to cleave and prone to breakage. The polycrystalline diamond composite, in spite of overcoming the faults of single crystal diamonds, has additional faults relating to wear and heat resistance because it contains sintering aids.

A diamond wire drawing die is known from EP-A-0 494 799, which comprises a single layer of a gaseous phase synthesised polycrystalline diamond having a preferred orientation, the grain size being from under 1 µm to over tens of µm.

It is an object of the present invention to provide a diamond wire drawing die or a diamond plate, for example, suitable for such a die, which is made of a gaseous phase synthesized polycrystalline diamond. Another object of the present invention is to provide a high quality diamond wire drawing die or a diamond plate, for example suitable for such a die, which has a bonding surface between the first and second polycrystalline diamond layers. A reduction portion of the diamond wire drawing die is located near the bonding surface.

Another object of the present invention is to provide a diamond wire drawing die in which the hole is made substantially perpendicular to the bonding surface.

Another object of the present invention is to provide a diamond wire drawing die in which the hole is substantially parallel to the bonding surface and the bonding surface is located substantially in the central portion of the hole.

Another object of the present invention is to provide a method to produce such a diamond wire drawing die.

The applicable objects are solved in accordance with the present invention respectively by a diamond wire drawing die including the features of claim 1 or a method of producing the same including the features of claim 5 or 6 or by a diamond plate including the features of claim 8. Detailed embodiments are described in the dependent claims.

The disclosed process for manufacturing a diamond wire drawing die comprises the following:
· A process to synthesize the first polycrystalline diamond layer on a substrate by a gaseous phase method
· A process to remove the substrate
· A process to synthesize the second polycrystalline diamond layer on the first polycrystalline diamond layer's surface to which the substrate adhered before being removed.
· A process to penetrate a hole in the first and the second polycryatalline diamond layers so that the hole crosses the bonding surface between the first and the second polycrystalline diamond layers.

The other process for manufacturing a diamond wire drawing die is different from the above process in die hole direction. The die hole is parallel to the bonding surface and the bonding surface is located substantially in the central portion of the hole.

Fig.1 is a schematic process diagram for making a central portion of the diamond wire drawing die according to a preferred embodiment of the present invention.

Fig.2 is a schematic cross sectional view of the diamond wire drawing die which was made in example 1.

Fig.3 is a schematic process diagram for making a central portion of the diamond wire drawing die which was made in example 2.

Fig.4 is a schematic cross sectional view of the internal structure at the die hole portion of a diamond wire drawing die.

Fig.5 shows a particle size distribution obtained in Example 3.

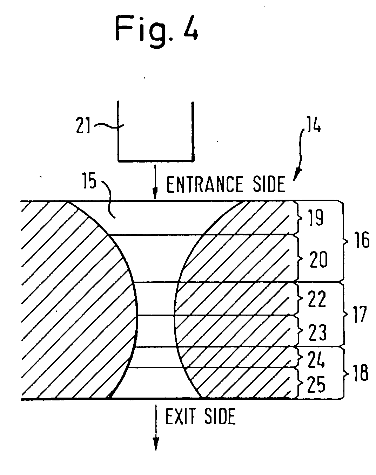

Fig.4 is schematic cross sectional view of the internal structure at the die hole portion of a diamond wire drawing die according to a prior technique. As shown in Fig.4, the internal structure at the hole portion (15) of the central portion (14) of a diamond wire drawing die consists of an entrance portion (16), a reduction portion (17) and an exit portion (18). The entrance portion (16) consists of a so-called entrance part or a bell part (19) and an approach part (20). The so-called entrance part or the bell part (19) is the entrance for wire (21) to be drawn, and is provided to allow lubricant to easily flow into the hole. The approach part (20) is provided to inhibit wire vibration, to fix the wire to be drawn, and to allow lubricant to easily flow into the hole. The reduction portion (17) consists of a reduction part (22) and a bearing part (23). The reduction part (22) reduces the wire (21) to be drawn, and is an important part because it influences the property of a wire drawing die and the quality of the drawn wire. The bearing part (23) influences the diameter and surface roughness of the drawn wire (21). The exit portion (18) consists of a back-relief part (24) and an exit part (25). The back-relief part (24) reinforces the bearing part (23) during wire (21) drawing. The exit part (25) is responsible for threading the hole with the fine tip of the wire (21) before drawing.

Referring to Fig.4, a drawing process of the wire (21) is explained hereafter. Initially, the wire (21) to be drawn is threaded into the entrance portion (16). Next, the wire (21) contacts the reduction portion (17) and is plastically deformed into a desired shape, diameter and surface roughness and is then drawn away from the exit portion (18).

The wire (21) is reduced in diameter and improved in physical properties such as yield strength and surface roughness during these drawing processes.

Recently, since it has become possible to synthesize diamond using a gaseous phase method, developments of applied products are actively proceeding which utilize the characteristics of diamond made by the gaseous phase method. Currently, however the present situation does not allow diamond made by the gaseous phase method to be applied to a wire drawing die. It is easy to consider using synthesized diamond made by a gaseous phase diamond on a substrate in this form when it is intended to use synthesized diamond made by a gaseous phase diamond for a wire drawing die. However, since the reduction portion of the wire drawing die is constructed by a comparatively large particle of columner structure diamond, which grows during gaseous phase synthesizing, there is a possibility of cleaving the same as a single crystal diamond, and its strength is insufficient to allow it to utilize a diamond made by a gaseous phases.

It is possible to a certain extent to control the microstructure of the gaseous phase synthesized diamond by changing the synthesizing condition. However, it is very difficult to make a uniform microstructure of fine particles in the thickness direction.

When a diamond is grown on the substrate by the gaseous phase synthesizing method, the fine nuclei develop in the initial stage and then grow to form a film. Although the particle size in the initial stage is remarkably influenced by previous substrate treatment and synthesizing conditions, it is possible to synthesize a diamond having a diameter of not more than 0.5 µm. Therefore, a high performance of the diamond wire drawing die is expected when a small particle portion is formed at the reduction portion.

After numerous experiments to solve the above faults, the inventors have completed the present invention in which a diamond has a suitable structure for the wire drawing die. The inventive diamond is obtained by the following process; a first polycrystalline diamond layer is initially synthesized on a substrate and then the substrate is removed, a second polycrystalline diamond layer is further synthesized on the first polycristalline diamond layer's surface such that its synythesizing direction is opposite that of the first diamond layer. The diamond wire drawing die of the present invention comprises; a wire contact portion which is a diamond synthesized by a gaseous phase method and a reduction portion of the wire drawing die which constitutes the finest structure of the diamond. The method of manufacturing the diamond wire drawing die of the present invention comprises;
a process to synthesize the first polycrystalline diamond layer on a substrate by a gaseous phase method, a process to remove the substrate, a process to synthesize the second polycrystalline diamond layer on the first polycrystalline diamond layer's surface to which the substrate adhered before being removed, a process to make a die hole penetrating the first and the second polycrystalline diamond layers so that the hole crosses the bonding surface of the first and second polycrystalline diamond layers.

The method of manufacturing the diamond wire drawing die of the present invention comprises;
a process to synthesize the first polycrystalline diamond layer on a substrate by a gaseous phase method, a process to remove the substrate, a process to synthesize the second polycrystalline diamond layer on the first polycrystalline diamond layer's surface to which the substrate adhered before removal, a process to make a die hole penetrating in a direction parallel to the bonding surface of the first and the second polycrystalline diamond layers so that the bonding surface is substantially in the central portion of die hole and the hole penetrates the first and the second polycrystalline diamond layers.

The diamond wire drawing die of the present invention comprises the diamond synthesized by a gaseous phase method which contacts the wire to be drawn. This diamond material produced by the gaseous phase method has a fine structure and also consists only of diamond, therefore it has superior wear, heat and chipping resistance as compared to a polycrystalline diamond composite.

Furthermore, the diamond produced by the gaseous phase method has a fine structure at the initial stage of diamond growth on a substrate and has a tendency to develop a more columner structure and a larger particle size. The diamond wire drawing die of the present invention is made by this process; after synthesizing the first polycrystalline diamond layer on a substrate by the gaseous phase method, the substrate is removed, and the second polycrystalline diamond layer is then synthesized on the first polycrystalline layer's surface to which the substrate adhered before the substrate was removed. Therefore, the diamond wire drawing die has finer diamond crystals near the bonding surface of the first and the second polycrystalline diamond layers than other portions. The greater the distance from the bonding surface, the larger is the diamond crystals.

Since the portion which has fine diamond crystals at the bonding surface of the first and the second polycrystalline diamond forms the reduction portion of a die hole, the diamond wire drawing die of the present invention has a hard and cleaving-resistant die hole. Therefore the diamond wire drawing die has superior wear resistance because the die hole is scarcely scarred by exfoliated diamonds.

Generally, tungsten and molybdenum wire are drawn at a high temperature to improve plasticity. However, higher drawing temperatures shorten the die life. As a polycrystalline diamond composite contains binder material, it has inferior heat resistance. However, a gaseous phase synthesized diamond is superior to the polycrystalline diamond composite in terms of heat resistance because the gaseous phase synthesized diamond does not contain the binder material and has nearly the same heat conductivity as a natural diamond.

Since the non-diamond ingredient in the gaseous phase synthesized diamond remarkably reduces wear resistance, it is desirable to decrease the amount of non diamond ingredient to as little as possible.

### Example 1

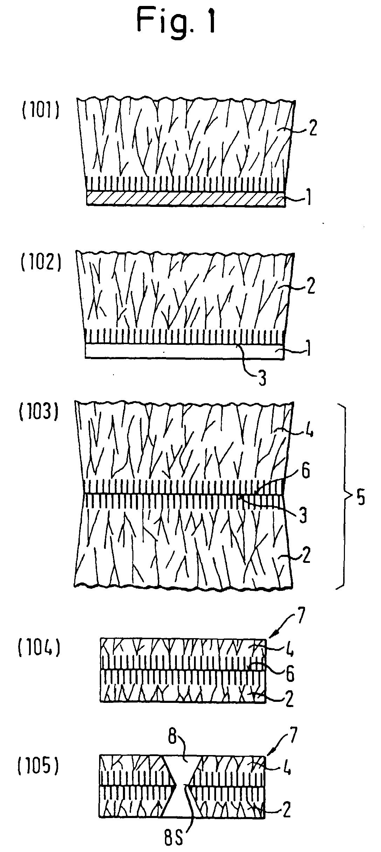

Fig.1 is a schematic process diagram for making a diamond wire drawing die according to a preferred embodiment of the present invention. Cross-sectional views shown in each step (101) ∼ (105) of Fig.1 schematically show the crystal structure of gaseous phase synthesized diamond which is used for the present invention. The higher the line density and the shorter line length, the finer the crystal structure the portion has in each cross sectional view. The process of the wire drawing die in the present invention is explained using Fig.1. The first polycrystalline diamond layer (2) was synthesized on a substrate (1) by the gaseous phase synthesizing method shown at step (101). The first polycrystalline diamond layer (2) was synthesized to 500 µm in thickness on a Si substrate (1) by hot filament CVD. The synthesizing condition is shown in Table 1.

**TABLE 1**

| Gas flow rate | CH₄/H₂ = 1.0 % |
|---|---|
| Pressure | 80 Torr |
| Filaement temperature | 2100 °C |
| Substrate temperature | 900 °C |

The substrate (1) was removed in step (102). The Si substrate with the first polycrystalline diamond layer (2) was dipped in hydrofluoric-nitric acid to remove the Si substrate. In step (103), the second polycrystalline diamond layer (4) was synthesized by the gaseous phase synthesizing method on the first polycrystalline diamond layer's surface which is the same surface as that to which the Si substrate adhered to the first polycrystalline diamond layer before removal. Thus, a multilayer (5) is formed. The second polycrystalline diamond layer (4) was synthesized to 500 µm in thickness on the side (3) of the first polycrystalline diamond layer by hot filament CVD. The synthesizing was carried out under the same conditions as the first polycrystalline diamond layer (2).

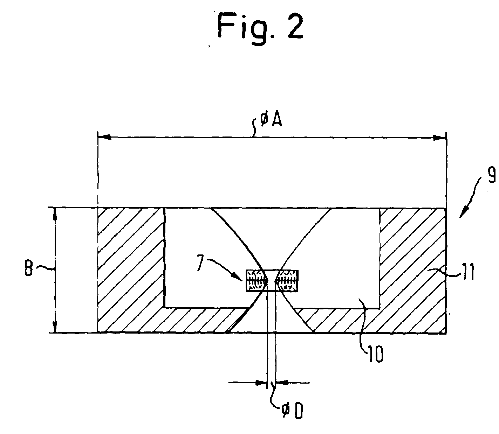

In step (104), a multilayer (5) is formed into a central portion (7) having a desired shape and size so that the bonding surface (6) between the first polycrystalline diamond layer (2) and the second polycrystalline diamond layer (4) is horizontal. The central portion (7) is processed by laser machining. In step (105), a die hole (8) is formed in the central portion. The die hole (8) is made through the first polycrystalline diamond layer and the second polycrystalline diamond layer across the bonding surface (6) of the first polycrystalline diamond layer and the second polycrystalline diamond layer by laser machining and ultrasonic machining in the central portion (7). As clearly shown in Fig.1, the central portion (7) of diamond wire drawing die provided by the above steps is made of diamond produced by the gaseous phase synthesizing method and the reduction portion (8S) of the die hole (8) penetrating the multilayer diamond has the finest structure in the multilayer polycrystalline diamond. Next, a diamond wire drawing die, of which a cross sectional view is shown in Fig.2, is provided using the central portion (7) having a die hole (8). As shown in Fig.2, the diamond wire drawing die (9) comprises the central portion (7), a reinforcing mount material (10) and the case (11). The central portion (7) is bonded to the reinforcing mount material (10) and the reinforcing material (10) is brazed to the case (11). The dimensions of the diamond wire drawing die are shown in Table 2 and 3. The angle in Table 3 is between the drawing direction and the tangent at the middle of each part.

**TABLE 2**

| Case dimension | Die hole diameter | Outer diameter | Height |
|---|---|---|---|
| | D (mm) | A (mm) | B (mm) |
| | 0.20 | 25 | 10 |

**TABLE 3**

| Name | Angle (') | Length (mm) |
|---|---|---|
| Entrance part | 60 | 0.20 |
| Approach part | 30 | 0.13 |
| Reduction part | 15 | 0.12 |
| Bearing part | 0 | 0.10 |
| Back-relief part | 30 | 0.15 |
| Exit part | 50 | 0.30 |

### Example 2

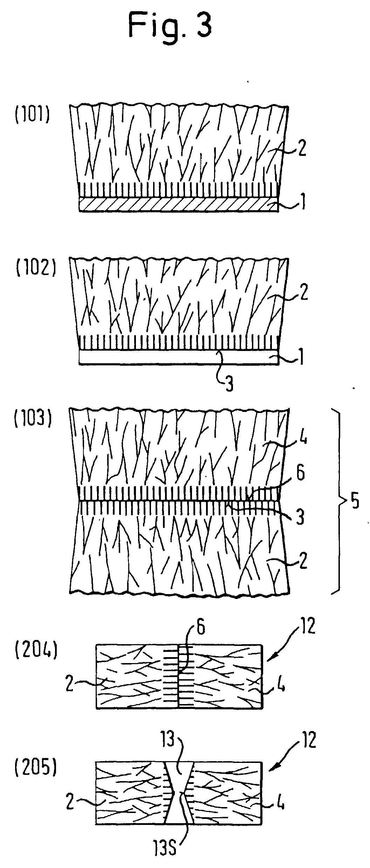

Fig.3 shows a schematic diagram of the steps used to produce the diamond wire drawing die of the preferred embodiment of the present invention. Referring to Fig.3, the process of making the inventive diamond wire drawing die is explained. Since the process of example 2, shown in Fig.3, is the same as the process of example 1, shown in Fig.1, except for steps (104) and (105), the same reference signs represent the same parts as in Fig.1 and are not explained further. The difference between the process of example 2, shown in Fig.3, and the process of example 1, shown in Fig.1, is that the central portion (12) is formed into a desired shape and size so that the bonding surface of the first polycrystalline diamond layer and the second polycrystalline diamond layer is vertical. In step (205), a die hole (13) in the multilayer is formed in a direction parallel to the bonding surface of the first polycrystalline diamond layer (2) and the second polycrystalline diamond layer (4) so that the center of the die hole is located near the bonded surface. The central portion (12) of the wire drawing die formed by the above process consists of diamond which is synthesized by the gaseous phase synthesizing method and the reduction portion (13S) in the die hole (13) has the finest polycrystalline diamond structure as clearly shown in Fig.3. The size and the shape of the hole portion (13) are the same as in example 1. Next, the central portion (12) having the hole portion (13) is made into a diamond wire drawing die similarly as in example 1.

### Comparative Example 1

After a polycrystalline diamond layer having a thickness of 1 mm was synthesized on a Si substrate under the same conditions under which the first polycrystalline diamond layer was synthesized in example 1 by the hot filament CVD method, the Si substrate was removed. Then, the polycrystalline diamond layer was processed into the central portion of a wire drawing die having a hole portion with the same shape and size as the polycrystalline diamond layer in example 1 using grinding, laser machining and ultrasonic machining, and the same diamond wire drawing die as produced in example 1 was obtained.

### Comparative Example 2

A polycrystalline diamond composite was used as a central portion which had the same shape and size as the polycrystalline diamond layer in example 1, and the same diamond wire drawing die as produced in example 1 was obtained.

Performance tests of the diamond wire drawing dies were carried out under the following conditions to evaluate the diamond wire drawing dies made by the above methods.

The condition of the first performance test

| | |
|---|---|
| drawing speed : | 200 m/min |
| drawn wire : | stainless steel |
| reduction in diameter : | 0.22 mm → 0.20 mm |
| amount of drawn wire : | 4 tons |

The diamond wire drawing dies prepared in example 1, example 2 and comparative example 2 showed the same results, but the diamond wire drawing die prepared in comparative example 1 was chipped. These results clearly showed that the present invented diamond wire drawing die was superior in strength to the diamond wire drawing die made by a simple gaseous phase synthesized diamond, because the reduction portion of the present inventive die was comprised of finer diamond particles compared to that of the simple gaseous phase synthesized diamond layer.

The conditions of the second performance test :

| | |
|---|---|
| drawing speed : | 300 m/min |
| drawn wire : | stainless steel |
| reduction in diameter : | 0.22 mm → 0.20 mm |
| amount of drawn wire : | 5 tons |

The wear of the diamond wire drawing die prepared in comparative example 2 proceeded remarkably well, but those of in example 1 and 2 did not. These results clearly showed that the present inventive diamond wire drawing die was superior in terms of heat resistance to the diamond wire drawing die made of a polycrystalline diamond composite, because the inventive die did not contain sintered diamond compact bonding material. Therefore, it is possible to improve drawing speed using the inventive wire drawing die.

### Example 3

The first polycrystalline diamond layer was synthesized to 500 µm in thickness on a Si substrate by hot filament CVD, and then the Si substrate was removed. The second polycrystalline layer was synthesized to 500 µm in thickness on the first polycrystalline diamond layer's surface to which the substrate adhered before being removed. The multilayered diamond was obtained in 1 mm thickness.

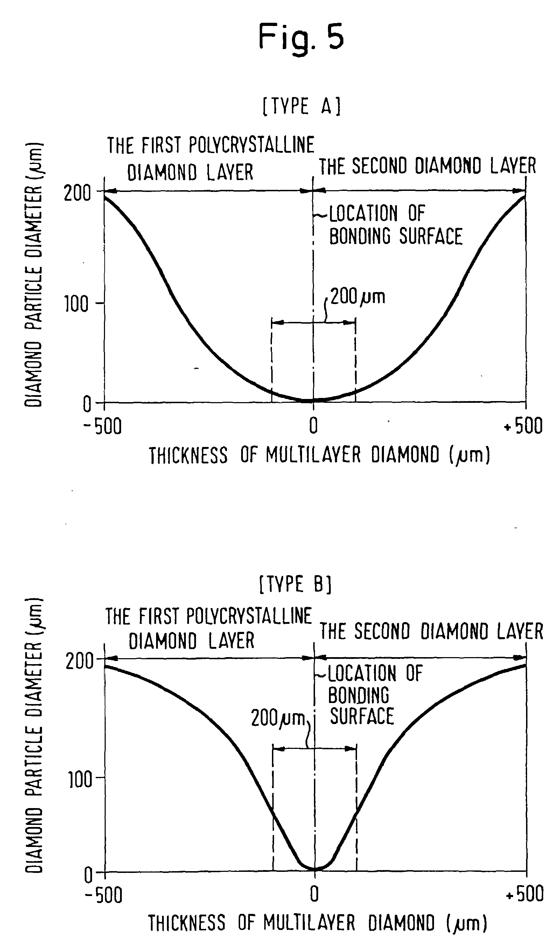

Type A and Type B in Fig.5 were provided by chaging th synthesized condition. A particle size of Type A consisted of finer diamond than Type B in the reduction portion. These multilayer diamonds were formed with the same dimensions as example 1. The first performance test was carried out using the diamond wire drawing die made of Type A and B.

The particle size of Type A was about 5 µm and that of Type B was about 50 µm. The wire drawing die made of Type A had no problem, on the other hand Type B was chipped.

The multilayer diamond of which the particle size of the reduction portion is not more than 30 µm, preferably not more than 10 µm, can be practically used for a wire drawing die.

Only the hot filament CVD method was used in examples 1, 2 and 3 as a gaseous phase synthesizing method. However, various kinds of low pressure gaseous phase synthesizing methods can be applied in this invention. For example, the thermal electron emission method, the plasma discharge method which decomposes and excites material gases, and the flame method can be used in this invention. For instance, a mixture gas which is mainly composed of hydrogen, and a hydrocarbon such as methane, ethane or propane, a kind of alcohol such as methanol or ethanol, or organic carbon compound such as ester, can be used in this invention. Further, the gas mixture may contain noble gases such as Ar or oxygen, carbon monoxide and water to such an extent as not to prohibit the synthesized reaction and not to depress the diamond layer performance. A diamond wire drawing die of the present invention may be employed successfully in drawing noble metal wire such as gold, silver or platinum, and other metal wire such as copper, brass, bronze, brass plated ferous metal, nickel, stainless steel, tungsten, molybdenum, tin, and as a nozzle for chemical fiber and reduction vinyl. In the process to remove the substrate (1) in step (102) of the examples, only the chemical method was used, but since the object of step (102) is to remove the substrate (1), machining work or any other method may be employed. Since the central portion of the diamond wire drawing die of this invention is composed of gaseous phase synthesized diamond, it is possible to make the finest particle portion of the diamond layer into a reduction portion by means of preparing the thickness of the first polycrystalline diamond layer and the thickness of the second polycrystalline diamond layer by changing the gaseous phase synthesizing condition. Since the shape of the hole portion of the wire drawing die depends on the material and the diameter of the wire to be drawn, it is possible to make the finest particle portion of the diamond layer into the wire contact portion of the drawing die.

The results are that the central portion of the diamond wire drawing die is a gaseous phase synthesized diamond and, furthermore, the wire contact portion of the die has the finest diamond particle size and the diamond wire drawing die of the present invention has superrior strength as well as superior wear and heat resistance.

The results are that the central portion of the diamond wire drawing die is a gaseous phase synthesized diamond and, furthermore, production cost is decreased compared with using a natural diamond.

The results are that the diamond wire drawing die of the present invention has superior strength as well as superior wear and heat resistance, thereby extending tool life.

## Claims

1. A diamond wire drawing die comprising a reinforcing mount material and a central portion made of gaseous phase synthesized polycrystalline diamond of different diamond particle sizes, wherein the synthesized diamond comprises a first synthesized polycrystalline diamond layer and a second polycrystalline diamond layer synthesized on the first layer in the opposite direction to the synthesization of the first layer, the layers thus being bonded together at a bonding surface, and wherein said synthesized diamond has the finest diamond particle size at a wire contact portion which is formed at the bonding surface.

2. Diamond wire drawing die according to claim 1, wherein a hole in which the wire contact portion is formed penetrates the synthesized diamond layers perpendicular to the bonding surface.

3. Diamond wire drawing die according to claim 1, wherein a hole in which the wire contact portion is formed penetrates the synthesized diamond layers, the center line of the hole being substantially parallel to the bonding surface.

4. Diamond wire drawing die according to claim 3, wherein the center line is located near to or on the bonding surface.

5. Process for manufacturing a diamond wire drawing die comprising the steps of synthesizing a first polycrystalline diamond layer on a substrate by a gaseous phase synthesizing method; removing the substrate; synthesizing a second polycrystalline diamond layer on the first polycrystalline diamond layer on the same surface as that from which the substrate was removed and in the opposite direction of synthesization of the first layer to form a synthesized polycrystalline diamond of different diamond particle sizes with the finest diamond particle size at a wire contact portion which is formed at the bonding surface between the two layers; and forming a hole which comprises the wire contact portion and penetrates the first polycrystalline diamond layer and the second polycrystalline diamond layer perpendicular to the bonding surface.

6. Process for manufacturing a diamond wire drawing die comprising the steps of synthesizing a first polycrystalline diamond layer on a substrate by a gaseous phase synthesizing method; removing the substrate; synthesizing a second polycrystalline diamond layer on the first polycrystalline diamond layer on the same surface as that from which the substrate was removed and in the opposite direction of synthesization of the first layer to form a synthesized polycrystalline diamond of different diamond particle sizes with the finest diamond particle size at a wire contact portion which is formed at the bonding surface between the two layers; and forming a hole which comprises the wire contact portion and extends parallel to the bonding surface so that the bonding surface is in the central portion of the hole.

7. Process for manufacturing the diamond wire drawing die according to claim 5 or 6, wherein the synthesized diamond is bonded to a mount material.

8. A diamond plate comprising a diamond made of gaseous phase synthesized polycrystalline diamond of different diamond particle sizes, wherein the synthesized diamond comprises a first synthesized polycrystalline diamond layer and a second polycrystalline diamond layer synthesized on the first layer in the opposite direction to the synthesization of the first layer, the layers thus being bonded together at a bonding surface, and wherein said synthesized diamond has the finest diamond particle size at the bonding surface.

## Patentansprüche

1. Diamant-Drahtziehwerkzeug, mit einem Verstärkungshaltematerial und einem mittleren Abschnitt aus gasphasensynthetisiertem polykristallinem Diamant mit verschiedenen Diamantpartikelgrößen, worin der synthetisierte Diamant eine erste synthetisierte polykristalline Diamantschicht und eine zweite polykristalline Diamantschicht umfaßt, die auf der ersten Schicht in der entgegengesetzten Richtung zur Synthetisierung der ersten Schicht synthetisiert ist, wobei die Schichten so an einer Bondoberfläche zusammengebondet sind, und worin der synthetisierte Diamant die feinste Diamantpartikelgröße an einem Drahtkontaktabschnitt aufweist, der an der Bondoberfläche gebildet ist.

2. Diamant-Drahtziehwerkzeug nach Anspruch 1, dadurch gekennzeichnet, daß ein Loch, in welchem der Drahtkontaktabschnitt gebildet ist, die synthetisierten Diamantschicht rechtwinklig zur Bondoberfläche durchdringt.

3. Diamant-Drahtziehwerkzeug nach Anspruch 1, dadurch gekennzeichnet, daß ein Loch, in welchem der Drahtkontaktabschnitt gebildet ist, die synthetisierten Diamantschichten durchdringt, wobei die Mittellinie des Loches im wesentlichen parallel zur Bondoberfläche ist.

4. Diamant-Drahtziehwerkzeug nach Anspruch 3, dadurch gekennzeichnet, daß die Mittellinie sich nahe oder auf der Bondoberfläche befindet.

5. Verfahren zum Herstellen eines Diamant-Drahtziehwerkzeugs, mit den Schritten Synthetisieren einer ersten polykristallinen Diamantschicht auf einem Substrat mittels eines Gasphasensynthetisierungsverfahrens; Entfernen des Substrats; Synthetisieren einer zweiten polykristallinen Diamantschicht auf der ersten polykristallinen Diamantschicht auf derselben Oberfläche wie der, von welcher das Substrat entfernt wurde und in der entgegengesetzten Richtung der Synthetisierung der ersten Schicht, um einen synthetisierten polykristallinen Diamant mit verschiedenen Diamantpartikelgrößen mit der feinsten Diamantpartikelgröße an einem Drahtkontaktabschnitt zu bilden, welcher an der Bondoberfläche zwischen den zwei Schichten gebildet wird; und Bilden eines Loches, welches den Drahtkontaktabschnitt umfaßt und die erste polykristalline Diamantschicht und die zweite polykristalline Diamantschicht rechtwinklig zur Bondoberfläche durchdringt.

6. Verfahren zum Herstellen eines Diamant-Drahtziehwerkzeugs, mit den Schritten Synthetisieren einer ersten polykristallinen Diamantschicht auf einem Substrat mittels eines Gasphasensynthetisierungsverfahrens; Entfernen des Substrats; Synthetisieren einer zweiten polykristallinen Diamantschicht auf der ersten polykristallinen Diamantschicht auf derselben Oberfläche wie der, von welcher das Substrat entfernt wurde und in der entgegengesetzten Richtung der Synthetisierung der ersten Schicht, um einen synthetisierten polykristallinen Diamanten mit verschiedenen Diamantpartikelgrößen mit der feinsten Diamantpartikelgröße an einem Drahtkontaktabschnitt zu bilden, welcher an der Bondoberfläche zwischen den zwei Schichten gebildet ist; und Bilden eines Loches, welches den Drahtkontaktabschnitt umfaßt und sich parallel zur Bondoberfläche erstreckt, so daß die Bondoberfläche im mittleren Abschnitt des Loches ist.

7. Verfahren zum Herstellen des Diamant-Drahtziehwerkzeugs nach Anspruch 5 oder 6, dadurch gekennzeichnet, daß der synthetisierte Diamant an ein Haltematerial gebondet ist.

8. Diamantplatte, umfassend einen Diamanten aus gasphasensynthetisiertem polykristallinem Diamant mit verschiedenen Diamantpartikelgrößen, worin der synthetisierte Diamant eine erste synthetisierte polykristalline Diamantschicht und eine zweite polykristalline Diamantschicht umfaßt, die auf der ersten Schicht in der entgegengesetzten Richtung zur Synthetisierung der ersten Schicht synthetisiert ist, wobei die Schichten so an einer Bondoberfläche zusammengebondet sind, und worin der synthetisierte Diamant die feinste Diamantpartikelgröße an der Bondoberfläche hat.

## Revendications

1. Filière de diamant destinée au filage de fils métalliques, comprenant un matériau de monture de renforcement et une partie centrale formée de diamant polycristallin synthétisé en phase gazeuse avec des dimensions particulaires différentes du diamant, dans laquelle le diamant synthétisé comporte une première couche de diamant polycristallin synthétisée et une seconde couche de diamant polycristallin synthétisée sur la première couche en sens opposé au sens de synthèse de la première couche, les couches étant ainsi liées à une surface de liaison, et le diamant synthétisé a sa plus petite dimension de particules de diamant dans la partie de contact avec un fil métallique qui est formée à la surface de liaison.

2. Filière de diamant destinée au filage de fils métalliques selon la revendication 1, dans laquelle le trou dans lequel est formée la partie de contact avec un fil traverse les couches de diamant synthétisées en direction perpendiculaire à la surface de liaison.

3. Filière de diamant destinée au filage de fils métalliques selon la revendication 1, dans laquelle le trou dans lequel est formée la partie de contact avec le fil métallique traverse les couches de diamant synthétisées, l'axe central du trou étant pratiquement parallèle à la surface de liaison.

4. Filière de diamant destinée au filage de fils métalliques selon la revendication 3, dans laquelle l'axe central est placé près de la surface de liaison ou sur celle-ci.

5. Procédé de fabrication d'une filière de diamant destinée au filage de fils métalliques, comprenant les étapes suivantes : la synthèse d'une première couche de diamant polycristallin sur un substrat par un procédé de synthèse en phase gazeuse, l'enlèvement du substrat, la synthèse d'une seconde couche de diamant polycristallin sur la première couche de diamant polycristallin, sur la surface dont a été retiré le substrat et avec un sens de synthèse opposé à celui ce la première couche pour la formation d'un diamant polycristallin synthétisé ayant des dimensions particulaires différentes du diamant, la dimension la plus petite de particules de diamant se trouvant au niveau de la partie de contact avec un fil métallique qui est formée à la surface de liaison entre les deux couches, et la formation d'un trou qui comprend la partie de contact avec un fil métallique et qui traverse la première couche et la seconde couche de diamant polycristallin en direction perpendiculaire à la surface de liaison.

6. Procédé de fabrication d'une filière de diamant destinée au filage de fils métalliques, comprenant les étapes suivantes : la synthèse d'une première couche de diamant polycristallin sur un substrat par un procédé de synthèse en phase gazeuse, l'enlèvement du substrat, la synthèse d'une seconde couche de diamant polycristallin sur la première couche de diamant polycristallin sur la surface dont le substrat a été retiré et avec un sens de synthèse opposé à celui de la première couche pour la formation d'un diamant polycristallin synthétisé ayant des dimensions particulaires différentes de diamant, la plus petite dimension particulaire du diamant se trouvant au niveau de la partie de contact avec un fil métallique qui est formée à la surface de liaison entre les deux couches, et la formation d'un trou qui comprend la partie de contact avec un fil métallique et qui est parallèle à la surface de liaison afin que la surface de liaison se trouve dans la partie centrale du trou.

7. Procédé de fabrication d'une filière de diamant destinée au filage de fils métalliques selon la revendication 5 ou 6, dans lequel le diamant synthétisé est lié à un matériau de montage.

8. Plaque de diamant comprenant un diamant formé d'un diamant polycristallin synthétisé en phase gazeuse avec différentes dimensions de particules de diamant, dans laquelle le diamant synthétisé comprend une première couche de diamant polycristallin synthétisée et une seconde couche de diamant polycristallin synthétisée sur la première couche et avec un sens de synthèse opposé à celui de la première couche, les couches étant ainsi liées mutuellement à une surface de liaison, et le diamant synthétisé a sa dimension particulaire la plus petite du diamant à la surface de liaison.
